(19) Europäisches Patentamt
European Patent Office
Office européen des brevets

(11) EP 2 428 843 A1

(12) EUROPEAN PATENT APPLICATION

(43) Date of publication:
**14.03.2012 Bulletin 2012/11**

(21) Application number: **11180515.6**

(22) Date of filing: **08.09.2011**

(51) Int Cl.:
***G03F 7/039*** *(2006.01)* ***G03F 7/20*** *(2006.01)*
***G03F 7/32*** *(2006.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **10.09.2010 US 381805 P**

(71) Applicants:
- **Rohm and Haas Electronic Materials LLC Marlborough, MA 01752 (US)**
- **Dow Global Technologies LLC Midland, MI 48674 (US)**

(72) Inventors:
- **Bae, Young Cheol Weston, MA 02493 (US)**
- **Cardolaccia, Thomas Marlborough, MA 01752 (US)**
- **Sun, Jibin Stoneham, MA 02180 (US)**
- **Arriola, Daniel J. Midland, MI 48640 (US)**
- **Frazier, Kevin A. Midland, MI 48642 (US)**

(74) Representative: **Buckley, Guy Julian Patent Outsourcing Limited 1 King Street Bakewell Derbyshire DE45 1DZ (GB)**

# (54) Photoresist compositions and methods of forming photolithographic patterns

(57) Provided are photoresist compositions useful in forming photolithographic patterns by a negative tone development process. Also provided are methods of forming photolithographic patterns by a negative tone development process and substrates coated with the photoresist compositions. The compositions, methods and coated substrates find particular applicability in the manufacture of semiconductor devices.

EP 2 428 843 A1

## Description

The invention relates generally to the manufacture of electronic devices. More specifically, this invention relates to photoresist compositions and to photolithographic methods which allow for the formation of fine patterns using a negative tone development process. The photoresist compositions include a copolymer formed in part from a monomer which includes a particular acetal moiety. Preferred compositions and methods of the invention can result in reduced thickness loss and improvement in pattern collapse margin in photolithographic processing.

In the semiconductor manufacturing industry, photoresist materials are used for transferring an image to one or more underlying layers, such as metal, semiconductor and dielectric layers, disposed on a semiconductor substrate, as well as to the substrate itself. To increase the integration density of semiconductor devices and allow for the formation of structures having dimensions in the nanometer range, photoresists and photolithography processing tools having high-resolution capabilities have been and continue to be developed.

One approach to achieving nm-scale feature sizes in semiconductor devices is the use of short wavelengths of light, for example, 193 nm or less, during exposure of chemically amplified photoresists. Immersion lithography effectively increases the numerical aperture of the lens of the imaging device, for example, a scanner having a KrF or ArF light source. This is accomplished by use of a relatively high refractive index fluid (i.e., an immersion fluid) between the last surface of the imaging device and the upper surface of the semiconductor wafer. The immersion fluid allows a greater amount of light to be focused into the resist layer than would occur with an air or inert gas medium.

The theoretical resolution limit as defined by the Rayleigh equation is shown below:

$$R = k_1 \frac{\lambda}{NA}$$

where $k_1$ is the process factor, $\lambda$ is the wavelength of the imaging tool and $NA$ is the numerical aperture of the imaging lens. When using water as the immersion fluid, the maximum numerical aperture can be increased, for example, from 1.2 to 1.35. For a $k_1$ of 0.25 in the case of printing line and space patterns, 193 nm immersion scanners would only be capable of resolving 36 nm half-pitch line and space patterns. The resolution for printing contact holes or arbitrary 2D patterns is further limited due to the low aerial image contrast with a dark field mask wherein the theoretical limit for $k_1$ is 0.35. The smallest half-pitch of contact holes is thus limited to about 50 nm. The standard immersion lithography process is generally not suitable for manufacture of devices requiring greater resolution.

Considerable effort has been made to extend the practical resolution capabilities of positive tone development in immersion lithography from both a materials and processing standpoint. One such example involves negative tone development (NTD) of a traditionally positive-type chemically amplified photoresist. NTD is an image reversal technique allowing for use of the superior imaging quality obtained with bright field masks for printing the critical dark field layers. NTD resists typically employ a resin having acid-labile (or acid-cleavable) groups and a photoacid generator. Exposure to actinic radiation causes the photoacid generator to form an acid which, during post-exposure baking, causes cleavage of the acid-labile groups giving rise to a polarity switch in the exposed regions. As a result, a difference in solubility characteristics is created between exposed and unexposed regions of the resist such that unexposed regions of the resist can be removed by particular developers, typically organic developers such as ketones, esters or ethers, leaving behind a pattern created by the insoluble exposed regions. Such a process is described, for example, in U.S. Patent No. 6,790,579, to Goodall et al. That document discloses a photoresist composition comprising an acid-generating initiator and a polycyclic polymer containing recurring acid labile pendant groups along the polymer backbone. The exposed areas can be selectively removed with an alkaline developer or, alternatively, the unexposed regions can be selectively removed by treatment with a suitable nonpolar solvent for negative tone development.

While conventional 193 nm photoresists can benefit from negative tone development in terms of improved aerial image quality, they tend to exhibit one or more disadvantages as compared with standard positive tone development techniques. The developed photoresist can, for example, demonstrate significant thickness loss as compared with the pre-exposed resist layer. Such thickness loss is believed to result from the cleavage of commonly employed acid labile groups such as tertiary alkyl ester groups from the resist layer. This can be particularly problematic during etching of an underlying layer if regions of the resist pattern become completely eroded away. This problem cannot necessarily be avoided by use of a thicker resist layer as other problems such as reduction in the depth of focus and pattern collapse can result from thicker films. The occurrence of pattern collapse in typical 193 nm resists is believed to be exacerbated by the relatively high content of (meth)acrylic acid units generated in exposed regions of the photoresist following cleavage of certain acid-labile groups, for example, tertiary alkyl ester and acetal leaving groups, from (meth)acrylate-based polymers. The (meth)acrylic acid units contribute to poor adhesion on organic and Si-based inorganic substrates due to the polarity mismatch between resist patterns and substrates. Another problem which can occur with the use of

conventional 193 nm photoresists is etch resistance loss. This problem can also result from the loss of acid-labile tertiary alkyl groups, which groups typically impart etch resistance to the photoresist patterns in positive tone development processes.

There is a continuing need in the art for improved photoresist compositions and photolithographic methods for negative tone development which allow for the formation of fine patterns in electronic device fabrication and which address one or more problems associated with the state of the art.

In accordance with the invention, a photoresist composition is provided. The photoresist composition comprises: a copolymer, comprising: a first unit formed from a monomer comprising: a polymerizable functional group; and a first moiety of the following formula (I) or formula (II):

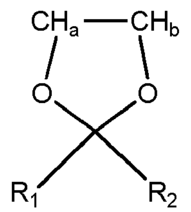
(I)

wherein: $R_1$ and $R_2$ are independently chosen from ($C_1$- $C_{10}$) linear, branched and cyclic organic groups, together optionally forming a ring; and a or b is 1 and the other of a or b is 1 or 2;

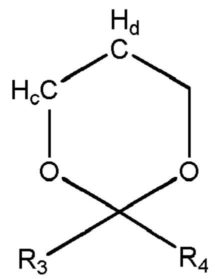
(II)

wherein: $R_3$ and $R_4$ are independently chosen from ($C_1$- $C_{10}$) linear, branched and cyclic organic groups, together optionally forming a ring; and c or d is 1 and the other of c or d is 1 or 2; and one or more additional units; wherein the copolymer is free of acid cleavable groups the cleavage of which would result in the formation of carboxylic acid groups; and a photoacid generator.

Also provided are methods of forming photolithographic patterns by negative tone development. The methods comprise: (a) providing a substrate comprising one or more layer to be patterned over a surface of the substrate; (b) applying a layer of the photoresist composition of the invention as described herein over the one or more layer to be patterned; (c) patternwise exposing the photoresist composition layer to actinic radiation; (d) heating the exposed photoresist composition layer in a post-exposure bake process; and (e) applying a developer to the photoresist composition layer. Unexposed regions of the photoresist layer are removed by the developer and exposed regions of the photoresist layer form a photoresist pattern over the one or more layer to be patterned.

Also provided are coated substrates. The coated substrates comprise a substrate and a layer of a photoresist composition of the invention as described herein over a surface of the sub strate.

Also provided are electronic devices formed by the inventive negative tone development methods as described herein.

As used herein: "g" means grams; wt% means weight percent; "L" means liter; "mL" means milliliter; "nm" means nanometer; "mm" means millimeter; "min" means minute; "h" means hour; "A" means Angstroms; "mol%" means molar percent; "Mw" means weight average molecular weight; "Mn" means number average molecular weight; the articles "a" and "an" mean one or more; and the term "copolymer" means a polymer derived from two or more monomers of different structure.

The present invention will be described with reference to the following drawings, in which like reference numerals denote like features, and in which:

FIG. 1A-E illustrates a process flow for forming a photolithographic pattern in accordance with the invention;
FIGS. 2-6 are contrast curves for photoresist compositions of the examples; and
FIG. 7A-C are SEM photomicrographs of patterns formed using photoresist compositions of the examples.

***Photoresist Compositions***

Preferred photoresist compositions of the invention when used to form very fine patterns in a negative tone development process can provide reduced top loss and reduced or eliminated pattern collapse as compared with conventional positive-tone photolithographic techniques. Preferred photoresists can further provide improved focus latitude and exposure latitude, as well as geometrically uniform resist patterns for lines and contact holes, and reduced defectivity. These benefits can be achieved when using the compositions described herein in dry lithography or immersion lithography processes.

A. Matrix Copolymer

The photoresist compositions include a matrix copolymer. The matrix copolymer as part of a layer of the photoresist composition undergoes a change in solubility in an organic developer as a result of reaction with acid generated from the photoacid generator following softbake, exposure to activating radiation and post exposure bake. The matrix copolymer includes a first unit formed from a monomer that includes a moiety having a ring structure and an acetal group. The two oxygen atoms and secondary carbon atom ("acetal secondary carbon atom") bonded to the oxygen atoms, characteristic of the acetal group, form a portion of the ring structure. Bonded to this acetal secondary carbon atom is a structure which can take the form of two groups pendant to the ring structure or which together with the acetal secondary carbon atom can take the form of a ring structure. The acetal secondary carbon atom together with the pendant group(s) are acid labile, undergoing a photoacid-promoted deprotection reaction on exposure to activating radiation and heat treatment. The resulting cleavage of the acetal secondary carbon atom and pendant group(s) is believed to result in the formation of hydroxy groups with the former acetal oxygen atoms. This causes the copolymer to become less soluble in an organic solvent used to develop the resist layer allowing for the formation of a negative-type image.

More particularly, the monomer comprises: a polymerizable functional group; and a first moiety of formula (I) or formula (II):

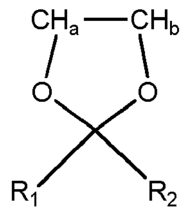

(I)

wherein: $R_1$ and $R_2$ are independently chosen from ($C_1$- $C_{10}$), preferably ($C_1$- $C_6$), linear, branched and cyclic organic groups, together optionally forming a ring; and a or b is 1 and the other of a or b is 1 or 2;

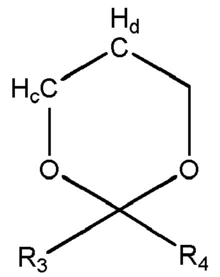

(II)

wherein: $R_3$ and $R_4$ are independently chosen from ($C_1$- $C_{10}$), preferably ($C_1$- $C_6$), linear, branched and cyclic organic groups, together optionally forming a ring; and c or d is 1 and the other of c or d is 1 or 2.

$R_1$, $R_2$, $R_3$ and $R_4$ can, for example, be: a ($C_1$- $C_{10}$), preferably ($C_1$- $C_6$), hydrocarbon such as ($C_1$- $C_6$)alkyl or ($C_4$- $C_7$)cycloalkyl; ($C_1$- $C_{10}$)alkoxy, ($C_1$- $C_{10}$)alkylcarbonyl, ($C_1$- $C_{10}$)alkoxycarbonyl, ($C_1$-$C_{10}$)alkylcarbonyloxy, alkylamine, alkylsulfur containing materials, and the like. Where $R_1$ and $R_2$ or $R_3$ and $R_4$ together form a ring, such ring is typically a C4 to C6 cycloalkane. The $R_1$, $R_2$, $R_3$ and $R_4$ groups can optionally be substituted, meaning that one or more hydrogen atom can be replaced by another atom or group.

The monomer preferably further includes a lactone, cyclic ether or cyclic alkane attached to the first moiety, for example, such that the first moiety is pendant to or fused to the lactone, cyclic ether or cyclic alkane. Preferred

lactones are chosen from those having five-membered ring structures. Preferred cyclic ethers are chosen from those having five- and six-membered ring structures. Preferred cyclic alkanes are chosen from those having six-membered ring structures. The lactone, cyclic ether or cyclic alkane is typically bonded directly to the polymerizable group but can optionally be bonded to the polymerizable group through a spacer unit, for example, a spacer unit chosen from linear and branched aliphatic, optionally with one or more linking moiety chosen from -O-, -S-, -COO- and -$CONR_5$-, wherein $R_5$ is chosen from hydrogen and ($C_1$-$C_{10}$) linear, branched and cyclic hydrocarbons. The $R_5$ hydrocarbon can optionally be substituted. Where a lactone, cyclic ether or cyclic alkane is present in the monomer, the first moiety is preferably bonded indirectly to the polymerizable group through the lactone, cyclic ether or cyclic alkane. The first moiety can, for example, form a fused ring structure with or be pendant to the lactone, cyclic ether or cyclic alkane. Suitable structures for the first moiety and lactone, cyclic ether or cyclic alkane include, for example, those derived from naturally occurring carbohydrates including sugars such as glucose and fructose reacted with ketones. Such materials are commercially available.

The monomer can further comprise one or more additional moiety of the formula (I) or formula (II) described above, the first and additional such moieties being the same or different. When an additional such moiety is present, the monomer will typically also include a lactone, cyclic ether or cyclic alkane as described above. The first and additional moieties can be present in the monomer in various configurations. For example, in the case of a first and second such moiety, one of the first and second moieties can be fused to the lactone, cyclic ether or cyclic alkane as described above and the other of the first and second moieties can be pendant to the lactone, cyclic ether or cyclic alkane, or both the first and second moieties can be fused to or pendant to the lactone, cyclic ether or cyclic alkane.

The polymerizable functional group in the monomer can be chosen, for example, from (meth)acrylate, vinyl and non-aromatic cyclic olefins (endocyclic double bond) such as norbornene, such as those of the following general formulae (P-A), (P-B) and (P-C):

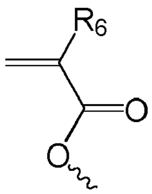

(P-A)

wherein $R_6$ is chosen from hydrogen and C1 to C3 alkyl;

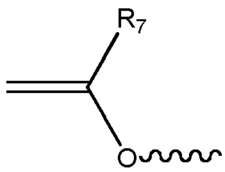

(P-B)

wherein $R_7$ is chosen from hydrogen and C1 to C3 alkyl; and

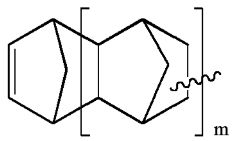

(P-C)

wherein m is an integer from 0 to 3. $R_6$ can optionally be substituted, for example, by replacing one or more hydrogen atom with a halogen such as fluorine. Preferably, the polymerizable group of the monomer and other monomer units is a (meth)acrylate group of formula (P-A).

Without limitation, suitable monomers of formula I or II include, for example, the following:

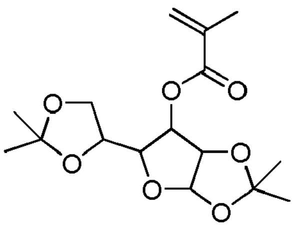

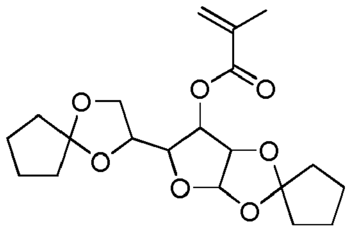

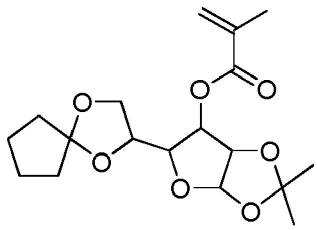

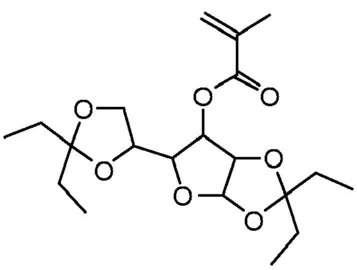

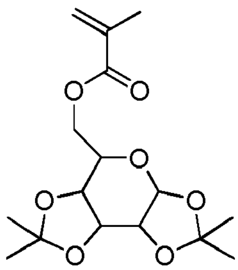

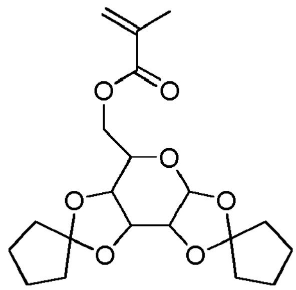

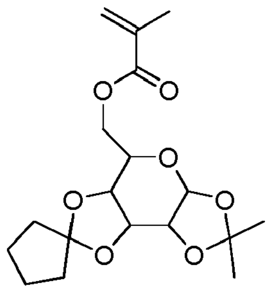

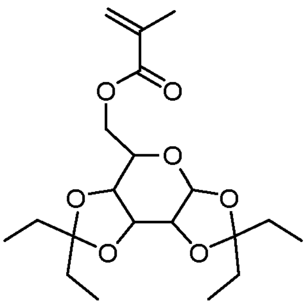

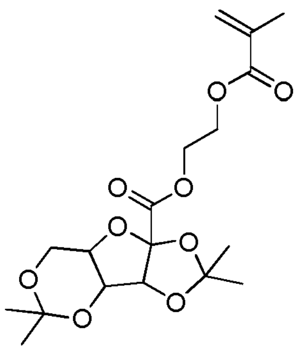

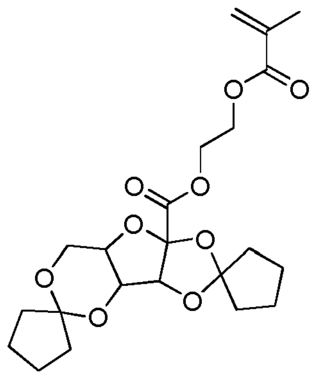

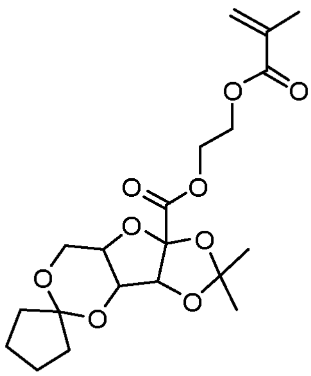

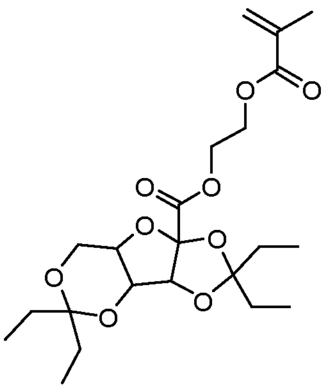

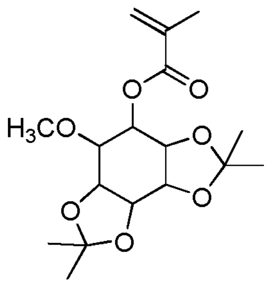

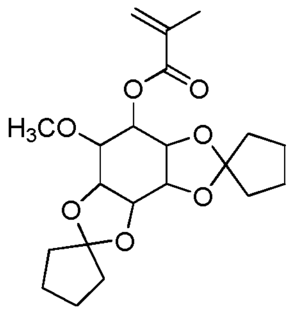

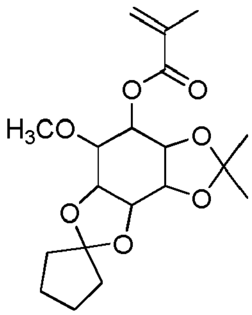
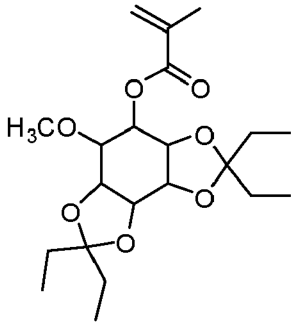
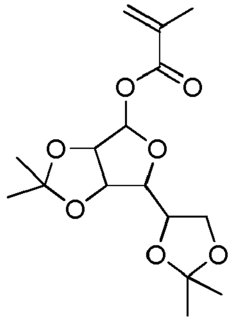
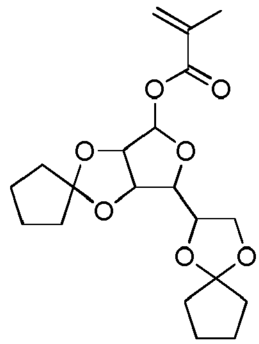

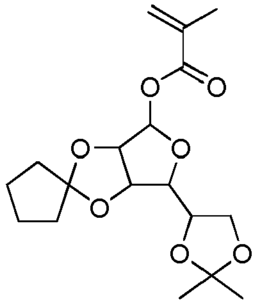
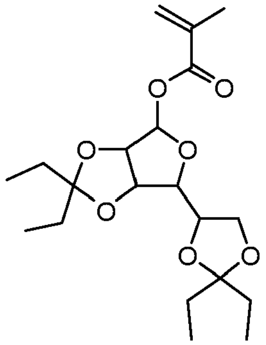
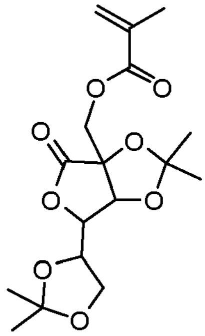
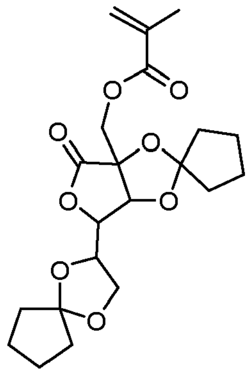

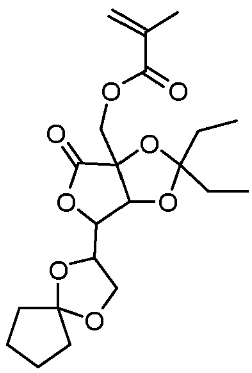
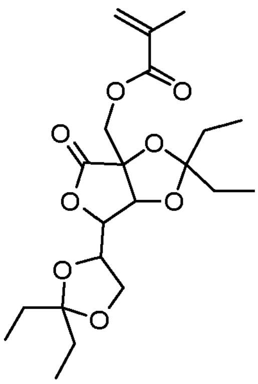
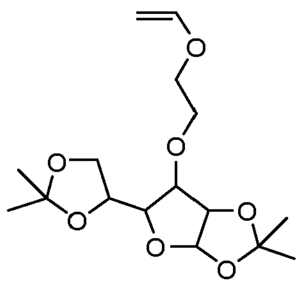
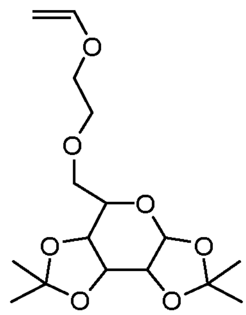

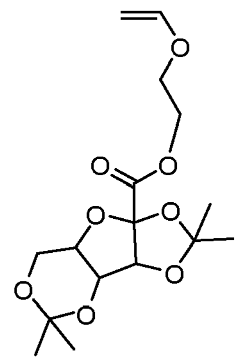
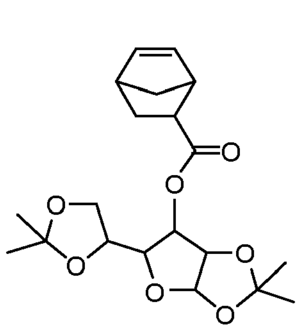
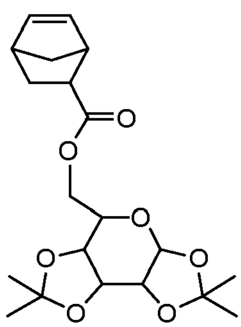

While particular polymerizable groups have been exemplified in the above monomers, it should be clear that other polymerizable groups such as those of above-described formulae (P-A), (P-B) and (P-C) can be used.

In addition to the first unit described above, the matrix copolymer includes one or more additional units. Typically, the additional units will include the same polymerizable group as that used in the first monomer but may include different

polymerizable groups, for example, those of formula (P-A), (P-B) and/or (P-C) as described above, in the same polymer backbone. Suitable additional monomeric units for the copolymer include, for example, one or more of the following: monomeric units formed from a monomer comprising a moiety of formula (I) or (II) which is different from the first unit; monomeric units containing ethers, lactones or esters, such as 2-methyl-acrylic acid tetrahydro-furan-3-yl ester, 2-methyl-acrylic acid 2-oxo-tetrahydrofuran-3-yl ester, 2-methyl-acrylic acid 5-oxo-tetrahydro-furan-3-yl ester, 2-methyl-acrylic acid 3-oxo-4,10-dioxa-tricyclo [5.2.1.02,6] dec-8-yl ester, 2-methyl-acrylic acid 3-oxo-4-oxa-tricyclo [5.2.1.02,6] dec-8-yl ester, 2-methyl-acrylic acid 5-oxo-4-oxa-tricyclo [4.2.1.03,7] non-2-yloxycarbonylmethyl ester, acrylic acid 3-oxo-4-oxa-tricyclo [5.2.1.02,6] dec-8-yl ester, and 2-methyl-acrylic acid 5-oxo-4-oxa-tricyclo [4.2.1.03,7] non-2-yl ester, and 2-methyl-acrylic acid tetrahydro-furan-3-yl ester; monomeric units having polar groups such as alcohols and fluorinated alcohols, such as 2-methyl-acrylic acid 3-hydroxy-adamantan-1-yl ester, 2-methyl-acrylic acid 2-hydroxy-ethyl ester, 6-vinyl-naphthalen-2-ol, 2-methyl-acrylic acid 3,5-dihydroxy-adamantan-1-yl ester, 2-methyl-acrylic acid 6-(3,3,3-trifluoro-2-hydroxy-2-trifluoromethyl-propyl)-bicyclo [2.2.1] hept-2-yl, and 2-bicyclo [2.2.1] hept-5-en-2-ylmethyl-1,1,1,3,3,3-hexafluoro-propan-2-ol; monomeric units having acid labile moieties other than an acid labile moiety which results in the formation of a carboxylic acid group after cleavage, such as 2-methyl-acrylic acid 2-(1-ethoxy-ethoxy)-ethyl ester, 2-methyl-acrylic acid 2-ethoxymethoxy-ethyl ester, 2-methyl-acrylic acid 2-methoxymethoxy-ethyl ester, 2-(1-Ethoxy-ethoxy)-6-vinylnaphthalene, 2-ethoxymethoxy-6-vinyl-naphthalene, and 2-methoxymethoxy-6-vinylnaphthalene.

The first unit and the additional units of the copolymer are free of acid cleavable groups the cleavage of which would result in the formation of carboxylic acid groups, such that the matrix copolymer is free of such carboxylic acid-forming acid cleavable groups. Typical such acid cleavable groups include ester groups that contain a tertiary non-cyclic alkyl carbon such as t-butyl, or a tertiary alicyclic carbon such as methyladamantyl or ethylfenchyl covalently linked to a carboxyl oxygen of an ester of the matrix polymer. Such groups are commonly used in 193 nm chemically amplified photoresists. As described above, the presence of high levels of carboxylic acid groups in the matrix polymer at the time of resist development can lead to pattern collapse. As a consequence of the absence of these acid cleavable groups, the photoresist compositions of the invention typically do not exhibit a positive tone contrast in aqueous base developers conventionally used in positive tone development processes. Such aqueous base developers include, for example, quaternary ammonium hydroxide solutions such as a tetra-alkyl ammonium hydroxide solutions such as tetramethyl ammonium hydroxide (TMAH) solutions, typically 0.26 N tetramethylammonium hydroxide. Thus, in contrast to known positive-type resist systems which include a matrix polymer having a carboxylic acid-inducing acid cleavable group, exposed regions of the photoresist compositions of the invention after post-exposure bake are substantially insoluble in an aqueous base developer. It is further believed that the presence of acid labile groups which are bulky, for example, tertiary alkyl ester labile groups such as alkyl adamantyl groups, commonly used in 193 nm photoresist polymers, can contribute to significant thickness loss and/or etch loss as compared with the pre-exposed resist layer.

For imaging at sub-200 nm wavelengths such as 193 nm, the matrix polymer is typically substantially free (e.g., less than 15 mol%) of phenyl, benzyl or other aromatic groups where such groups are highly absorbing of the radiation. The copolymer can contain repeat units that contain a hetero atom, particularly oxygen and/or sulfur, for example, one or more chosen from: heteroalicyclic units fused to the polymer backbone; fused carbon alicyclic units such as provided by polymerization of a norbornene group; and carbocyclic aryl units substituted with one or more hetero-atom (e.g., oxygen or sulfur) containing groups, for example, hydroxy naphthyl groups.

The weight average molecular weight $M_w$ of the matrix polymer is typically less than 100,000, for example, from 5000 to 100,000, more typically from 5000 to 15,000. Suitable matrix polymers can readily be made by persons skilled in the art using commercially available starting materials. The matrix polymer is present in the resist composition in an amount sufficient to obtain a uniform coating of desired thickness. Typically, the matrix polymer is present in the composition in an amount of from 70 to 95 wt% based on total solids of the resist composition.

B. Photoacid Generator

The photosensitive composition further comprises a photoacid generator (PAG) employed in an amount sufficient to generate a latent image in a coating layer of the composition upon exposure to activating radiation. For example, the photoacid generator will suitably be present in an amount of from about 1 to 20 wt% based on total solids of the photoresist composition. Typically, lesser amounts of the PAG will be suitable for chemically amplified resists.

Suitable PAGs are known in the art of chemically amplified photoresists and include, for example: onium salts, for example, triphenylsulfonium trifluoromethanesulfonate, (p-tert-butoxyphenyl)diphenylsulfonium trifluoromethanesulfonate, tris(p-tert-butoxyphenyl)sulfonium trifluoromethanesulfonate, triphenylsulfonium p-toluenesulfonate; nitrobenzyl derivatives, for example, 2-nitrobenzyl p-toluenesulfonate, 2,6-dinitrobenzyl p-toluenesulfonate, and 2,4-dinitrobenzyl p-toluenesulfonate; sulfonic acid esters, for example, 1,2,3-tris(methanesulfonyloxy)benzene, 1,2,3-tris(trifluoromethanesulfonyloxy)benzene, and 1,2,3-tris(p-toluenesulfonyloxy)benzene; diazomethane derivatives, for example, bis(benzenesulfonyl)diazomethane, bis(p-toluenesulfonyl)diazomethane; glyoxime derivatives, for example, bis-O-(p-toluenensulfonyl)-a-dimethylglyoxime, and bis-O-(n-butanesulfonyl)-a-dimethylglyoxime; sulfonic acid ester derivatives of an N-hydroxyimide compound, for example, N-hydroxysuccinimide methanesulfonic acid ester, N-hydroxysuccinimide trifluoromethanesulfonic acid ester; and halogen-containing triazine compounds, for example, 2-(4-methoxyphenyl)-4,6-bis (trichloromethyl)-1,3,5-triazine, and 2-(4-methoxynaphthyl)-4,6-bis(trichloromethyl)-1,3,5-triazine. One or more of such PAGs can be used.

C. Solvent

Suitable solvents for the photoresist compositions of the invention include, for example: glycol ethers such as 2-methoxyethyl ether (diglyme), ethylene glycol monomethyl ether, and propylene glycol monomethyl ether; propylene glycol monomethyl ether acetate; lactates such as methyl lactate and ethyl lactate; propionates such as methyl propionate, ethyl propionate, ethyl ethoxy propionate and methyl-2-hydroxy isobutyrate; Cellosolve esters such as methyl Cellosolve acetate; aromatic hydrocarbons such as toluene and xylene; and ketones such as methylethyl ketone, cyclohexanone and 2-heptanone. A blend of solvents such as a blend of two, three or more of the solvents described above also are suitable. The solvent is typically present in the composition in an amount of from 90 to 99 wt%, more typically from 95 to 98 wt%, based on the total weight of the photoresist composition.

D. Other Components

The photoresist compositions can also include other optional materials. For example, the compositions can include one or more of actinic and contrast dyes, anti-striation agents, plasticizers, speed enhancers, sensitizers, and the like. Such optional additives if used are typically present in the composition in minor amounts such as from 0.1 to 10 wt% based on total solids of the photoresist composition.

A preferred optional additive of resist compositions of the invention is an added base, for example, a caprolactam, which can enhance resolution of a developed resist relief image. Other suitable basic additives include: alkyl amines such as tripropylamine and dodecylamine, aryl amines such as diphenylamine, triphenylamine, aminophenol, 2-(4-aminophenyl)-2-(4-hydroxyphenyl)propane, and the like. The added base is suitably used in relatively small amounts, for example, from 0.01 to 5 wt%, preferably from 0.1 to 2 wt%, based on total solids of the photoresist composition.

Surface active polymers can optionally be used as an additive in the photoresist formulation in order to simplify the immersion lithographic process by avoiding the need for a top-coat layer over the resist layer. Top-coat layers are typically used to prevent resist components such as photoacid generators from contaminating the imaging lens surface. Surface active polymer additives added to the photoresist formulations migrate to the surface during the coating process due to their relatively low surface free energy. The surface active polymer additives should have a lower surface free energy than the matrix polymer to allow the surface active polymer to migrate to the surface. A typical surface free energy of the surface active polymer additives is from 10 to 40 $mJ/m^2$. Suitable surface active polymers are known in the art and include, for example, those disclosed by Tsibouklis and Nevell (Advanced Materials, 2003, 15, pp.647-650). Exemplary suitable polymer additives include, for example, poly(n-butyl acrylate), poly(n-butyl methacrylate), poly(i-butyl acrylate), poly(i-butyl methacrylate), poly(diethyl siloxane), poly(vinyl butyrate), polytetrahydrofuran, poly(propylene glycol), poly(tetramethylene oxide) and fluorinated polymers. The one or more additive polymer typically may be present in the photoresist composition in relatively small amounts and still provide effective results. The content of the additive polymer may depend, for example, on whether the lithography is a dry or immersion-type process. For example, the additive polymer lower limit for immersion lithography is generally dictated by the need to prevent leaching of the resist components. A higher additive polymer content will typically result in pattern degradation. The one or more polymer additive is typically present in the compositions of the invention in an amount of from 0.1 to 10 wt%, more typically from 1 to 5 wt%, based on total solids of the photoresist composition. The weight average molecular weight of the additive polymer is typically less than 400,000, for example from 5000 to 50,000.

***Preparation of Photoresist Compositions***

The photoresists used in accordance with the invention are generally prepared following known procedures. For example, a photoresist composition of the invention can be prepared by dissolving the components of the photoresist in the solvent component. The desired total solids content of the photoresist will depend on factors such as the particular polymers in the composition, final layer thickness and exposure wavelength. Typically the solids content of the photoresist varies from 1 to 10 wt%, more typically from 2 to 5 wt%, based on the total weight of the photoresist composition.

***Negative Tone Development Methods***

The invention further provides methods for forming a photoresist relief image and producing an electronic device using photoresists of the invention. The invention also provides novel articles of manufacture comprising substrates

coated with a photoresist composition of the invention. Processes in accordance with the invention will now be described with reference to FIG. 1A-E, which illustrates an exemplary process flow for forming a photolithographic pattern by negative tone development.

FIG. 1A depicts in cross-section a substrate 100 which may include various layers and features. The substrate can be of a material such as a semiconductor, such as silicon or a compound semiconductor (e.g., III-V or II-VI), glass, quartz, ceramic, copper and the like. Typically, the substrate is a semiconductor wafer, such as single crystal silicon or compound semiconductor wafer, and may have one or more layers and patterned features formed on a surface thereof. One or more layers to be patterned 102 may be provided over the substrate 100. Optionally, the underlying base substrate material itself may be patterned, for example, when it is desired to form trenches in the substrate material. In the case of patterning the base substrate material itself, the pattern shall be considered to be formed in a layer of the substrate.

The layers may include, for example, one or more conductive layers such as layers of aluminum, copper, molybdenum, tantalum, titanium, tungsten, alloys, nitrides or silicides of such metals, doped amorphous silicon or doped polysilicon, one or more dielectric layers such as layers of silicon oxide, silicon nitride, silicon oxynitride, or metal oxides, semiconductor layers, such as single-crystal silicon, and combinations thereof. The layers to be etched can be formed by various techniques, for example, chemical vapor deposition (CVD) such as plasma-enhanced CVD, low-pressure CVD or epitaxial growth, physical vapor deposition (PVD) such as sputtering or evaporation, or electroplating. The particular thickness of the one or more layers to be etched 102 will vary depending on the materials and particular devices being formed.

Depending on the particular layers to be etched, film thicknesses and photolithographic materials and process to be used, it may be desired to dispose over the layers 102 a hard mask layer 104 and/or a bottom antireflective coating (BARC) 106 over which a photoresist layer 108 is to be coated. Use of a hard mask layer 104 may be desired, for example, with very thin resist layers, where the layers to be etched require a significant etching depth, and/or where the particular etchant has poor resist selectivity. Where a hard mask layer is used, the resist patterns to be formed can be transferred to the hard mask layer which, in turn, can be used as a mask for etching the underlying layers 102. Suitable hard mask materials and formation methods are known in the art. Typical materials include, for example, tungsten, titanium, titanium nitride, titanium oxide, zirconium oxide, aluminum oxide, aluminum oxynitride, hafnium oxide, amorphous carbon, silicon oxynitride and silicon nitride. The hard mask layer 104 can include a single layer or a plurality of layers of different materials. The hard mask layer can be formed, for example, by chemical or physical vapor deposition techniques.

A bottom antireflective coating 106 may be desirable where the substrate and/or underlying layers would otherwise reflect a significant amount of incident radiation during photoresist exposure such that the quality of the formed pattern would be adversely affected. Such coatings can improve depth-of-focus, exposure latitude, linewidth uniformity and CD control. Antireflective coatings are typically used where the resist is exposed to deep ultraviolet light (300nm or less), for example, KrF excimer laser light (248nm) or ArF excimer laser light (193nm). The antireflective coating 106 can comprise a single layer or a plurality of different layers. Suitable antireflective materials and methods of formation are known in the art. Antireflective materials are commercially available, for example, those sold under the AR™ trademark by Rohm and Haas Electronic Materials LLC (Marlborough, MA USA), such as AR™40A and AR™124 antireflectant materials.

A photoresist composition as described herein is applied on the substrate over the antireflective layer 106 (if present) to form a photoresist layer 108. The photoresist composition can be applied to the substrate by spin-coating, dipping, roller-coating or other conventional coating technique. Of these, spin-coating is typical. For spin-coating, the solids content of the coating solution can be adjusted to provide a desired film thickness based upon the specific coating equipment utilized, the viscosity of the solution, the speed of the coating tool and the amount of time allowed for spinning. A typical thickness for the photoresist layer 108 is from about 500 to 3000Å.

The photoresist layer can next be softbaked to minimize the solvent content in the layer, thereby forming a tack-free coating and improving adhesion of the layer to the substrate. The softbake can be conducted on a hotplate or in an oven, with a hotplate being typical. The softbake temperature and time will depend, for example, on the particular material of the photoresist and thickness. Typical softbakes are conducted at a temperature of from about 90 to 150°C, and a time of from about 30 to 90 seconds.

The photoresist layer 108 is next exposed to activating radiation 110 through a first photomask 112 to create a difference in solubility between exposed and unexposed regions. References herein to exposing a photoresist composition to radiation that is activating for the composition indicates that the radiation is capable of forming a latent image in the photoresist composition. The photomask has optically transparent and optically opaque regions 113, 114 correspond to regions of the resist layer to remain and be removed, respectively, in a subsequent development step for a positive-acting material as illustrated. The exposure wavelength is typically sub-400 nm, sub-300 nm or sub-200 nm, with 248nm and 193nm being typical. The methods find use in immersion or dry (non-immersion) lithography techniques. The exposure energy is typically from about 10 to 80 mJ/$cm^2$, dependent upon the exposure tool and the components of the photosensitive composition.

As shown in FIG. 1B, the exposed resist layer is made up of unexposed and exposed regions 108a, 108b. Following exposure of the photoresist layer 108, a post-exposure bake (PEB) is performed. The PEB can be conducted, for example, on a hotplate or in an oven. Conditions for the PEB will depend, for example, on the particular photoresist composition and layer thickness. The PEB is typically conducted at a temperature of from about 80 to 150°C, and a time of from about 30 to 90 seconds.

The exposed photoresist layer is next developed to remove unexposed regions 108a, leaving exposed regions 108b forming a resist pattern as shown in FIG. 1C. The developer is typically an organic developer, for example, a solvent chosen from ketones, esters, ethers, hydrocarbons, and mixtures thereof. Suitable ketone solvents include, for example, acetone, 2-hexanone, 5-methyl-2-hexanone, 2-heptanone, 4-heptanone, 1-octanone, 2-octanone, 1-nonanone, 2-nonanone, diisobutyl ketone, cyclohexanone, methylcyclohexanone, phenylacetone, methyl ethyl ketone and methyl isobutyl ketone. Suitable ester solvents include, for example, methyl acetate, butyl acetate, ethyl acetate, isopropyl acetate, amyl acetate, propylene glycol monomethyl ether acetate, ethylene glycol monoethyl ether acetate, diethylene glycol monobutyl ether acetate, diethylene glycol monoethyl ether acetate, ethyl-3-ethoxypropionate, 3-methoxybutyl acetate, 3-methyl-3-methoxybutyl acetate, methyl formate, ethyl formate, butyl formate, propyl formate, ethyl lactate, butyl lactate and propyl lactate. Suitable ether solvents include, for example, dioxane, tetrahydrofuran and glycol ether solvents, for example, ethylene glycol monomethyl ether, propylene glycol monomethyl ether, ethylene glycol monoethyl ether, propylene glycol monoethyl ether, diethylene glycol monomethyl ether, triethylene glycol monoethyl ether and methoxymethyl butanol. Suitable amide solvents include, for example, N-methyl-2-pyrrolidone, N,N-dimethylacetamide and N,N-dimethylformamide. Suitable hydrocarbon solvents include, for example, aromatic hydrocarbon solvents such as toluene and xylene. In addition, mixtures of these solvents, or one or more of the listed solvents mixed with a solvent other than those described above or mixed with water can be used. Of these, 2-heptanone and 5-methyl-2-hexanone are particularly preferred. Other suitable solvents include those used in the photoresist composition.

The solvent can be present in the developer as a substantially pure material, for example, in an amount greater than 95 wt%, greater than 98 wt% or greater than 99 wt%, based on the total weight of the developer. In the case a mixture of solvents are used in the developer, the boiling points of the solvents are preferably similar. The solvents of the developer are typically present in an amount of from 50 wt% to 100 wt%, more typically from 80 wt% to 100 wt%, based on the total weight of the developer.

The developer material may include optional additives, for example, surfactants such as described above with respect to the photoresist. Such optional additives typically will be present in minor concentrations, for example, in amounts of from about 0.01 to 5 wt% based on the total weight of the developer.

The developer can be applied to the substrate by known techniques, for example, by spin-coating or puddle-coating. The development time is for a period effective to remove the unexposed regions of the photoresist, with a time of from 5 to 30 seconds being typical. Development is typically conducted at room temperature. The development process can be conducted without use of a cleaning rinse following development. In this regard, it has been found that the development process can result in a residue-free wafer surface rendering such extra rinse step unnecessary.

The BARC layer 106, if present, is selectively etched using resist pattern 108b as an etch mask, exposing the underlying hardmask layer 104. The hardmask layer is next selectively etched, again using the resist pattern 108b as an etch mask, resulting in patterned BARC and hardmask layers 106', 104', as shown in FIG. 1D. Suitable etching techniques and chemistries for etching the BARC layer and hardmask layer are known in the art and will depend, for example, on the particular materials of these layers. Dry-etching processes such as reactive ion etching are typical. The resist pattern 108b and patterned BARC layer 106' are next removed from the substrate using known techniques, for example, oxygen plasma ashing.

Using the hardmask pattern 104' as an etch mask, the one or more layers 102 are selectively etched. Suitable etching techniques and chemistries for etching the underlying layers 102 are known in the art, with dry-etching processes such as reactive ion etching being typical. The patterned hardmask layer 104' can next be removed from the substrate surface using known techniques, for example, a dry-etching process such as reactive ion etching. The resulting structure is a pattern of etched features 102' as illustrated in FIG. IE. In an alternative exemplary method, it may be desirable to pattern the layer 102 directly using the resist pattern 108b without the use of a hardmask layer 104. Whether direct patterning is employed will depend on factors such as the materials involved, resist selectivity, resist pattern thickness and pattern dimensions.

The negative tone development methods of the invention are not limited to the exemplary methods described above. For example, the photoresist compositions of the invention can be used in a negative tone development double exposure method for making contact holes. An exemplary such process is a variation of the technique described with reference to FIG. 1, but using an additional exposure of the photoresist layer in a different pattern than the first exposure. In this process, the photoresist layer is exposed to actinic radiation through a photomask in a first exposure step. The photomask includes a series of parallel lines forming the opaque regions of the mask. Following the first exposure, a second exposure of the photoresist layer is conducted through a second photomask that includes a series of lines in a direction perpendicular to those of the first photomask. The resulting photoresist layer includes unexposed regions,

once-exposed regions and twice-exposed regions.

Following the second exposure, the photoresist layer is post-exposure baked and developed using a developer as described above. Unexposed regions corresponding to points of intersection of the lines of the two masks are removed, leaving behind the once- and twice-exposed regions of the resist. The resulting structure can next be patterned as described above with reference to FIG. 1. This method is particularly suited to formation of contact holes in the manufacture of electronic devices.

EXAMPLES

**Matrix Polymer Synthesis**

The following monomers were employed in the syntheses of copolymers in the examples below:

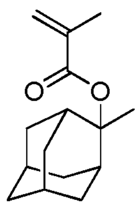

MAMA

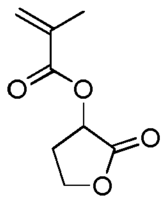

α-GBLMA

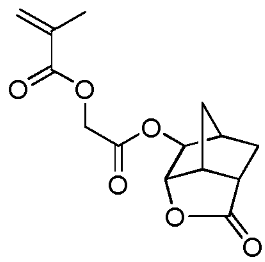

MNLMA

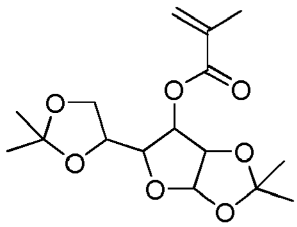

IPGFMA

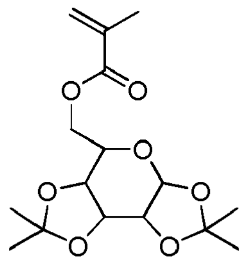

IPGPMA

Synthesis of poly(MAMA/α-GBLMA/MNLMA)

27.48 g of MAMA, 15.96 g of α-GBLMA, and 6.57 g of MNLMA were dissolved in 62 g of PGMEA. The mixture was degassed by bubbling with nitrogen for 20 min. A 500 mL flask equipped with a condenser, nitrogen inlet and mechanical stirrer was charged with 35 g of PGMEA and the solution brought to a temperature of 80°C. 2.52 g of V601 (dimethyl-2,2-azodiisobutyrate) dissolved in 2.0 g of PGMEA was charged into the flask. The monomer solution was fed into the reactor at a rate of 27.42 mL/h. After 1 h, 1.26 g of V-601 dissolved in 2.0 g of PGMEA was added to the reactor and the monomer feeding was carried out for another 3 hours. After monomer feeding was complete, the polymerization mixture was stirred for an additional 3 hours at 80°C. After a total of 7 hours polymerization time (4 hours feeding and 3 hours stirring), the polymerization mixture was cooled down to room temperature. Precipitation was carried out in 2.0 L of isopropyl alcohol. After filtration, the polymer was dried, re-dissolved in 162 g of THF, re-precipitated into 3.2 L of isopropyl alcohol, filtered, and dried in a vacuum oven at 45°C for 48 hours to give 41.5 g (Mw = 6,498 and Mw/Mn = 1.62) of the following "Polymer A":

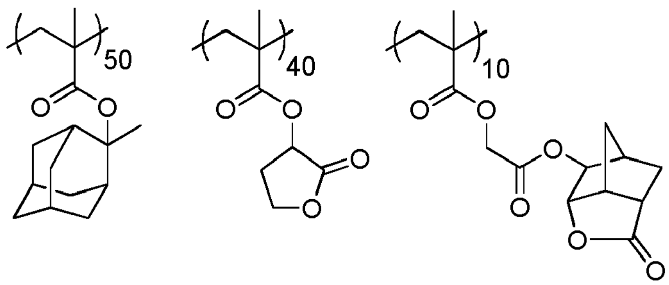

Synthesis of poly(IPGFMA/α-GBLMA/MNLMA)

15.77 g of IPGFMA, 6.54g of α-GBLMA, and 2.69 g of MNLMA were dissolved in 31 g of PGMEA. The mixture was degassed by bubbling with nitrogen for 20 min. A 500 mL flask equipped with a condenser, nitrogen inlet and mechanical stirrer was charged with 18 g of PGMEA and the solution brought to a temperature of 80°C. 1.03 g of V601 (dimethyl-2,2-azodiisobutyrate) dissolved in 1.0 g of PGMEA was charged into the flask. The monomer solution was fed into the reactor at a rate of 13.0 mL/h. After 1 h, 0.52 g of V-601 dissolved in 1.0 g of PGMEA was added to the reactor and the monomer feeding was carried out for another 3 hours. After monomer feeding was complete, the polymerization mixture was stirred for an additional 3 hours at 80°C. After a total of 7 hours polymerization time (4 hours feeding and 3 hours stirring), the polymerization mixture was cooled down to room temperature. Precipitation was carried out in 1.0 L of isopropyl alcohol. After filtration, the polymer was dried, re-dissolved in 52 g of THF, re-precipitated into 1.1 L of isopropyl alcohol, filtered, and dried in a vacuum oven at 45°C for 48 hours to give 18.5 g (Mw = 14,378 and Mw/Mn = 1.75) of the following "Polymer B":

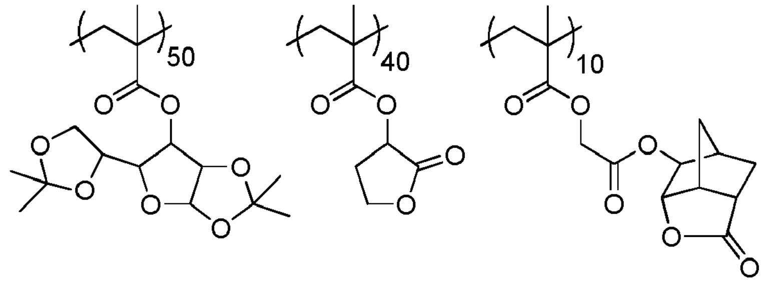

Synthesis of poly(IPGPMA/α-GBLMA/MNLMA)

15.77 g of IPGPMA, 6.54 g of α-GBLMA, and 2.69 g of MNLMA were dissolved in 31 g of PGMEA. The mixture was degassed by bubbling with nitrogen for 20 min. A 500 mL flask equipped with a condenser, nitrogen inlet and mechanical stirrer was charged with 18 g of PGMEA and the solution brought to a temperature of 80°C. 1.03 g of V601 (dimethyl-2,2-azodiisobutyrate) dissolved in 1.0 g of PGMEA was charged into the flask. The monomer solution was fed into the reactor at a rate of 13.0 mL/h. After 1 h, 0.52 g of V-601 dissolved in 1.0 g of PGMEA was added to the reactor and the monomer feeding was carried out for another 3 hours. After monomer feeding was complete, the polymerization mixture was stirred for an additional 3 hours at 80°C. After a total of 7 hours polymerization time (4 hours feeding and 3 hours stirring), the polymerization mixture was cooled down to room temperature. Precipitation was carried out in 1.0 L of isopropyl alcohol. After filtration, the polymer was dried, re-dissolved in 52 g of THF, re-precipitated into 1.1 L of isopropyl alcohol, filtered, and dried in a vacuum oven at 45°C for 48 hours to give 18.0 g (Mw = 15,239 and Mw/Mn = 1.84) of the following "Polymer C":

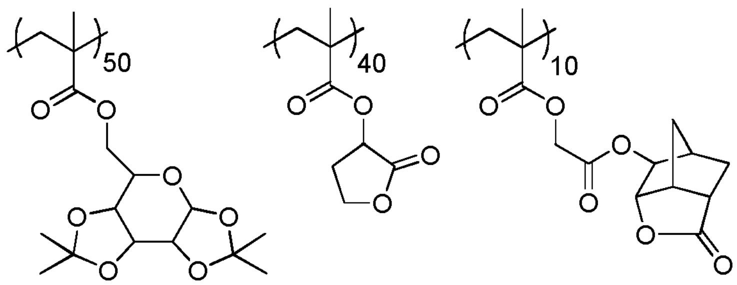

Synthesis of poly(IPGFMA)

15.00 g of IPGFMA was dissolved in 18.56 g of PGMEA. The mixture was degassed by bubbling with nitrogen for 20 min. A 500 mL flask equipped with a condenser, nitrogen inlet and mechanical stirrer was charged with 10.56 g of PGMEA and the solution brought to a temperature of 80°C. 0.42 g of V601 (dimethyl-2,2-azodiisobutyrate) dissolved in 0.60 g of PGMEA was charged into the flask. The monomer solution was fed into the reactor at a rate of 8.22 mL/h. After 1 h, 0.21 g of V-601 dissolved in 0.60 g of PGMEA was added to the reactor and the monomer feeding was carried out for another 3 hours. After monomer feeding was complete, the polymerization mixture was stirred for an additional 3 hours at 80°C. After a total of 7 hours polymerization time (4 hours feeding and 3 hours stirring), the polymerization mixture was cooled down to room temperature. Precipitation was carried out in 0.6 L of isopropyl alcohol. After filtration, the polymer was dried, re-dissolved in 24 g of THF, re-precipitated into 0.4 L of isopropyl alcohol, filtered, and dried in a vacuum oven at 45°C for 48 hours to give 7.4 g (Mw = 9,887 and Mw/Mn = 1.65) of the following "Polymer D":

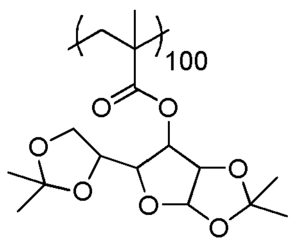

Synthesis of poly(IPGPMA)

15.00 g of IPGPMA was dissolved in 18.56 g of PGMEA. The mixture was degassed by bubbling with nitrogen for 20 min. A 500 mL flask equipped with a condenser, nitrogen inlet and mechanical stirrer was charged with 10.56 g of PGMEA and the solution brought to a temperature of 80°C. 0.42 g of V601 (dimethyl-2,2-azodiisobutyrate) dissolved in 0.60 g of PGMEA was charged into the flask. The monomer solution was fed into the reactor at a rate of 8.22 mL/h. After 1 h, 0.21 g of V-601 dissolved in 0.60 g of PGMEA was added to the reactor and the monomer feeding was carried out for another 3 hours. After monomer feeding was complete, the polymerization mixture was stirred for an additional 3 hours at 80°C. After a total of 7 hours polymerization time (4 hours feeding and 3 hours stirring), the polymerization mixture was cooled down to room temperature. Precipitation was carried out in 0.6 L of isopropyl alcohol. After filtration, the polymer was dried, re-dissolved in 22 g of THF, re-precipitated into 0.4 L of isopropyl alcohol, filtered, and dried in a vacuum oven at 45°C for 48 hours to give 8.8 g (Mw = 10,546 and Mw/Mn = 1.64) of the following "Polymer E":

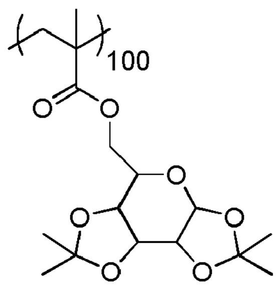

**Additive Polymer Synthesis: Poly(n-BMA)**

13.01 g of n-butyl methacrylate (nBMA) was dissolved in 7 g of THF. The mixture was degassed by bubbling with nitrogen for 20 min. A 500 mL flask equipped with a condenser, nitrogen inlet and mechanical stirrer was charged with 8 g of THF and the solution brought to a temperature of 67°C. 2.11 g of V601 (dimethyl-2,2-azodiisobutyrate, 10.0 mol% with respect to monomers) was dissolved in 2 g of THF and charged into the flask. The monomer solution was fed into the reactor at a rate of 6.29 mL/h. The monomer feeding was carried out for 3 hours 30 min. After monomer feeding was complete, the polymerization mixture was stirred for an additional 30 min at 67°C. After a total of 4 hours polymerization time (3 hours 30 min feeding and 30 min stirring), 7 g of THF was added to the reactor and the polymerization mixture was cooled down to room temperature. Precipitation was carried out in 0.4 L of cold methanol. After filtration, the polymer was dried in a vacuum oven at 60°C for 48 hours to give 8.4 g (Mw = 12,284 and Mw/Mn = 1.79) of the following "Additive A":

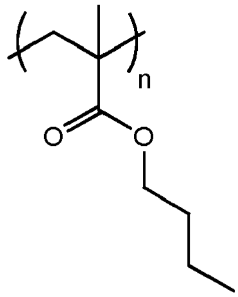

**Photoresist Composition Formulation**

Example 1 (Comparative)

2.921 g of Polymer A and 0.102 g of Additive A were dissolved in 28.980 g of propylene glycol monomethyl ether acetate (PGMEA), 19.320 g of cyclohexanone, and 48.300 g of methyl-2-hydroxyisobutyreate. To this mixture was added 0.361 g of "PAG A" described below, 0.007 g of 1-(tert-butoxycarbonyl)-4-hydroxypiperidine, 0.010 g of 1-(tert-butoxycarbonyl)-4-hydroxypiperidine and 0.005 g of POLYFOX® PF-656 surfactant (Omnova Solutions Inc.). The resulting mixture was rolled on a roller for six hours and then filtered through a Teflon filter having a 0.2 micron pore size.

PAG A

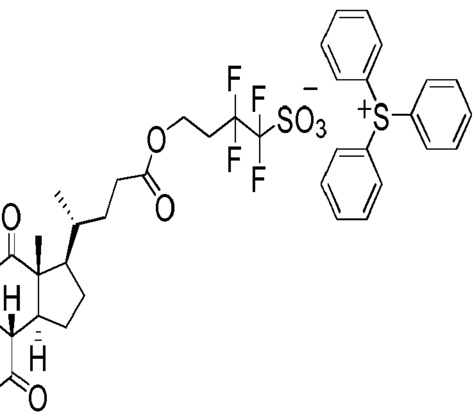

Examples 2-9 (Examples 4-6, 8 and 9 Comparative)

Photoresist compositions were prepared using the same procedures as Example 1, using the components and amounts as set forth in Table 1.

**TABLE 1**

| Ex. | Matrix Polymer | Additive A | PAGA | Quencher | Surfactant | Solvent A | Solvent B | Solvent C |
|---|---|---|---|---|---|---|---|---|
| 1 (Comp) | A (2.921) | 0.102 | 0.361 | 0.007 | 0.005 | 28.980 | 19.320 | 48.300 |
| 2 | B (2.921) | 0.102 | 0.361 | 0.007 | 0.005 | 28.980 | 19.320 | 48.300 |
| 3 | C (2.921) | 0.102 | 0.361 | 0.007 | 0.005 | 28.980 | 19.320 | 48.300 |
| 4 (Comp) | D (2.921) | 0.102 | 0.361 | 0.007 | 0.005 | 28.980 | 19.320 | 48.300 |
| 5 (Comp) | E (2.921) | 0.102 | 0.361 | 0.007 | 0.005 | 28.980 | 19.320 | 48.300 |
| 6 (Comp) | A (3.027) | 0 | 0.361 | 0.007 | 0.005 | 28.980 | 19.320 | 48.300 |
| 7 | B (3.027) | 0 | 0.361 | 0.007 | 0.005 | 28.980 | 19.320 | 48.300 |
| 8 (Comp) | D (3.027) | 0 | 0.361 | 0.007 | 0.005 | 28.980 | 19.320 | 48.300 |
| 9 (Comp) | E (3.027) | 0 | 0.361 | 0.007 | 0.005 | 28.980 | 19.320 | 48.300 |

Quencher: 1-(tert-butoxycarbonyl)-4-hydroxypiperidine; Surfactant: POLYFOX® PF-656 (Omnova Solutions Inc.); Solvent A: propylene glycol monomethyl ether acetate; Solvent B: cyclohexanone; Solvent C: methyl-2-hydroxyisobutyrate. All contents in grams. "Comp" = comparative example.

**Dry Lithographic Process and Contrast Evaluation**

Dry lithographic processing was carried out to obtain NTD contrast curves for each of the photoresist compositions on 200 mm silicon wafers using a TEL CleanTrack ACT 8 linked to an ASML/1100 scanner with a maximum numerical aperture (NA) of 0.75. Silicon wafers were spin-coated with AR™77 bottom-antireflective coating (BARC) material (Rohm and Haas Electronic Materials) and baked for 60 seconds at 205°C to yield a film thickness of 840 Å. Photoresist formulations of Examples 1-9 were coated on the BARC-coated wafers and soft-baked at 100°C for 60 seconds on a TEL CleanTrack ACT 8 coater/developer to provide a resist layer thickness of 1000 Å.

The photoresist-coated wafers were then exposed through a blank mask using 0.75 NA and a Quadrapole 30 illumination condition with 0.89 outer sigma and 0.64 inner sigma. The exposure was carried out with a starting dose of 1.0 $mJ/cm^2$ in increments of 0.2 $mJ/cm^2$ to expose 100 die in a 10x10 array on the wafer in a dose range from 1.0 to 20.8 $mJ/cm^2$. The exposed wafers were post-exposure baked at a temperature of 100 or 110°C for 60 seconds and then developed using 2-heptanone for 25 seconds on a TEL CleanTrack ACT 8 coater/developer. The remaining film thickness for different exposure doses was measured on a ThermaWave Optiprobe (KLA-Tencor) and NTD contrast curves were obtained by plotting remaining film thickness as a function of exposure dose. The resulting contrast curves can be seen in FIGS. 2-6. From the contrast curves, thickness loss for each photoresist layer was calculated based on the final plateau film thickness with increased exposure dose. The resulting film thicknesses losses are summarized in Table 2.

**TABLE 2**

| Example | Matrix Polymer | Additive Polymer | Thickness Loss (%) | Pattern Collapse |
|---|---|---|---|---|
| 1 (Comp) | A | A | ~40 | Yes |
| 2 | B | A | ~10 | No |
| 3 | C | A | ~10 | No |
| 4 (Comp) | D | A | ~90 | * |
| 5 (Comp) | E | A | ~98 | * |
| 6 (Comp) | A | - | ~36 | - |
| 7 | B | - | ~8 | - |
| 8 (Comp) | D | - | ~90 | - |

(continued)

| Example | Matrix Polymer | Additive Polymer | Thickness Loss (%) | Pattern Collapse |
|---|---|---|---|---|
| 9 (Comp) | E | - | ~97 | - |
| *Immersion lithographic processing for pattern collapse evaluation was not conducted due to insufficient NTD contrast for patterning. | | | | |

FIG. 2 shows the resulting contrast curves for the compositions of Examples 1-3. Comparative Example 1 which includes Polymer A, typical of conventional 193 nm photoresist compositions, was found to show severe thickness loss of about 40% after NTD. In contrast, Examples 2 and 3 were found to exhibit only about 10% thickness loss after NTD. Accordingly, replacement of the MAMA monomer of Polymer A with an IPGFMA monomer or IPGPMA monomer as in Polymer B or C, respectively, resulted in significantly improved post-NTD thickness retention.

FIG. 3 compares NTD contrast curves obtained for the resist compositions of Example 2 and Comparative Example 4 using Polymers B and D, respectively. The composition of Comparative Example 4 using Polymer D (IPGFMA homopolymer) provided unacceptable NTD contrast, resulting in a thickness loss of about 90%. However, when using a copolymer of IPGFMA with a lactone-containing methacrylic monomer as in Example 2, excellent NTD contrast resulted. The same observation was made with IPGPMA homopolymer ("Polymer E") in Comparative Example 5. As shown in FIG. 4 which provides NTD contrast curves for Example 3 and Comparative Example 5, the comparative example resulted in poor NTD contrast with a thickness loss of about 98%. When IPGPMA was copolymerized with a lactone-containing methacrylic monomer as in Polymer C of Example 3, excellent NTD contrast resulted. Based on these results, it is believed that copolymers comprising IPGFMA or IPGPMA and lactone-containing methacrylic monomers exhibit significantly improved NTD contrast as compared with IPGFMA or IPGPMA homopolymers, respectively.

As shown in FIGS. 5 and 6 and Table 2, similar results for NTD contrast were obtained for the photoresist compositions of Examples 6-9 which were formulated without using the surface active polymer (Additive A) as compared with Examples 1, 2, 4 and 5, respectively. The presence of a surface active polymer would therefore not be expected to adversely impact the obtained contrast of matrix polymers of the invention.

### Immersion Lithographic Process for Pattern Collapse Evaluation

300 mm silicon wafers were spin-coated with AR™40A antireflectant (Rohm and Haas Electronic Materials) to form a first bottom antireflective coating (BARC) on a TEL CLEAN TRAC LITHIUS i+ coater/developer. The wafer was baked for 60 seconds at 215°C, yielding a first BARC film thickness of 840 Å. A second BARC layer was next coated over the first BARC using AR™124 antireflectant (Rohm and Haas Electronic Materials), and was baked at 205°C for 60 seconds to generate a 200 Å top BARC layer. Photoresist formulations of Examples 1-3 were then coated on the dual BARC-coated wafers and soft-baked at 100°C for 60 seconds on a TEL CLEAN TRACK LITHIUS i+ coater/developer to provide a resist layer thickness of 1000 Å.

The photoresist-coated wafers were exposed through a mask on an ASML TWINSCAN XT:1900i immersion scanner with a maximum NA of 1.35 and using diffractive optical elements. Two exposure conditions were used for each resist composition. For a single exposure NTD process, C-Quad 20 illumination was used with 1.35 NA, 0.988 outer sigma, 0.9 inner sigma and XY polarization. For a double exposure NTD process, which involves double exposure of line/space patterns in a perpendicular direction to print contact hole images, the first exposure was carried out using a dipole illumination with 1.35 NA, 0.97 outer sigma, 0.82 inner sigma and X polarization. Immediately after the first exposure step, the wafers were exposed again with a different mask having lines perpendicular to lines of the first mask, using a dipole illumination with 1.35 NA, 0.97 outer sigma, 0.82 inner sigma and Y polarization. The exposed wafers were post-exposure baked at 100 to 120°C for 60 seconds and then developed using 2-heptanone for 25 seconds on a TEL CLEAN TRACK™ LITHIUS™ i+ coater/developer to give negative tone patterns. Critical dimensions (CDs) were measured on a Hitachi CG4000 CD SEM at various mask CDs and pitches and the patterns were inspected for the occurrence of pattern collapse.

The compositions of Examples 2 and 3 using Polymers B and C, respectively, exhibited superior pattern collapse margins as compared with the composition of Comparative Example 1 using Polymer A. FIG. 7A-C provides SEM photomicrograph images of CDs obtained with a mask CD of 40nm lines at 80nm pitch for the compositions of Examples 1-3, respectively, at 32mJ/cm$^2$. A dipole illumination condition was used with 1.35 NA, 0.97 outer sigma, 0.82 inner sigma and X polarization. Comparative Example 1 was found to exhibit severe pattern collapse while Examples 2 and 3 were found to provide excellent collapse margins.

## Claims

1. A photoresist composition, comprising:

a copolymer, comprising:

a first unit formed from a monomer comprising: a polymerizable functional group; and a first moiety of the following formula (I) or formula (II):

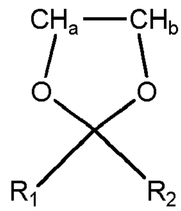

(I)

wherein: $R_1$ and $R_2$ are independently chosen from ($C_1$- $C_{10}$) linear, branched and cyclic organic groups, together optionally forming a ring; and a or b is 1 and the other of a or b is 1 or 2;

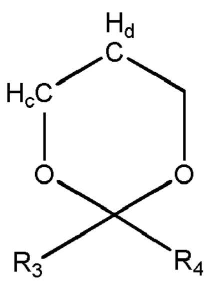

(II)

wherein: $R_3$ and $R_4$ are independently chosen from ($C_1$- $C_{10}$) linear, branched and cyclic organic groups, together optionally forming a ring; and c or d is 1 and the other of c or d is 1 or 2; and
one or more additional units;
wherein the copolymer is free of acid cleavable groups the cleavage of which would result in the formation of carboxylic acid groups; and

a photoacid generator.

2. The photoresist composition of claim 1, wherein the monomer further comprises a lactone, cyclic ether or cyclic alkane, the first moiety being linked to the polymerizable group through the lactone, cyclic ether or cyclic alkane.

3. The photoresist composition of claim 2, wherein the first moiety forms a fused ring structure with the lactone, cyclic ether or cyclic alkane.

4. The photoresist composition of claim 2, wherein the first moiety is pendant to the lactone, cyclic ether or cyclic alkane.

5. The photoresist composition of any of claims 1 to 4, wherein the monomer further comprises a second moiety of the formula (I) or formula (II), wherein the first and second moieties are the same or different.

6. The photoresist composition of any of claims 1 to 5, wherein the polymerizable group is a (meth)acrylate group.

7. The photoresist composition of any of claims 1 to 6, wherein the one or more additional units comprises a unit formed from a monomer containing a lactone moiety.

8. The photoresist composition of any of claims 1-7, further comprising a surface active polymer additive having a surface free energy less than that of the copolymer, wherein the surface free energy of the surface active polymer is from 10 to 40 mJ/m$^2$.

**9.** A coated substrate, comprising a substrate and a layer of a photoresist composition of any of claims 1 to 8 over a surface of the substrate.

**10.** A method of forming a photolithographic pattern by negative tone development, comprising:

(a) providing a substrate comprising one or more layer to be patterned over a surface of the substrate;
(b) applying a layer of a photoresist composition according to any of claims 1 to 8 over the one or more layer to be patterned;
(c) patternwise exposing the photoresist composition layer to actinic radiation;
(d) heating the exposed photoresist composition layer in a post-exposure bake process; and
(e) applying a developer to the photoresist composition layer, wherein unexposed regions of the photoresist layer are removed by the developer and exposed regions of the photoresist layer form a photoresist pattern over the one or more layer to be patterned.

FIG. 1A

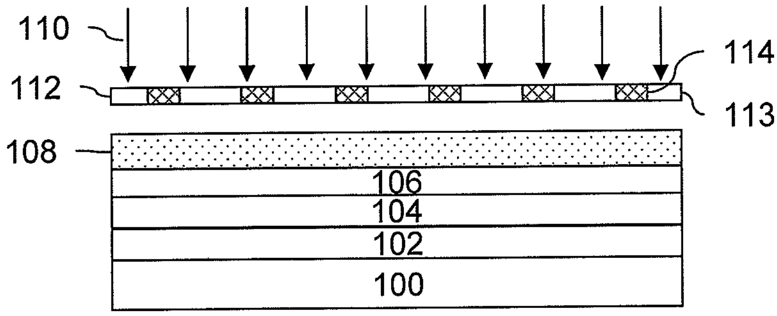


FIG. 1B

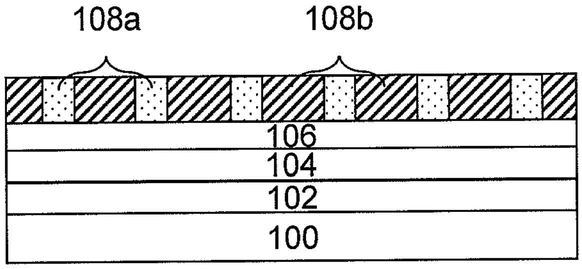


FIG. 1C

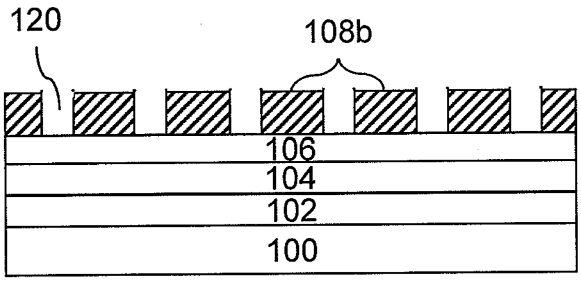


FIG. 1D

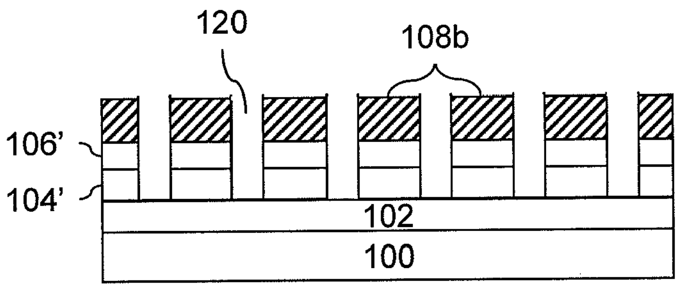


FIG. 1E

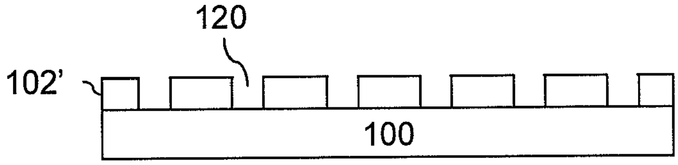

FIG. 2

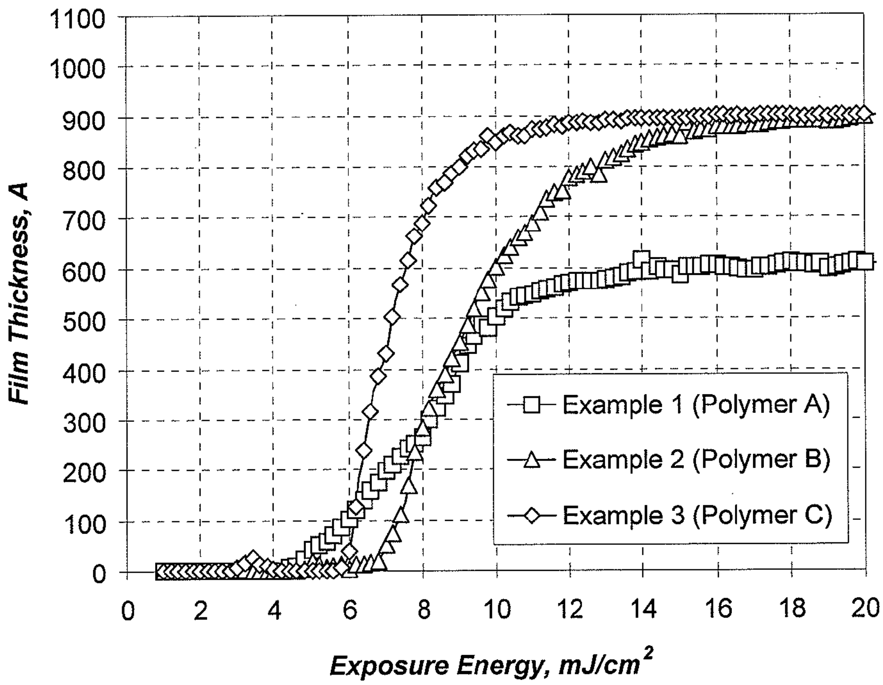
1100
1000
900
800
700
600
500
400
300
200
100
0
Film Thickness, A
0 2 4 6 8 10 12 14 16 18 20
Exposure Energy, mJ/cm2
Example 1 (Polymer A)
Example 2 (Polymer B)
Example 3 (Polymer C)

FIG. 3

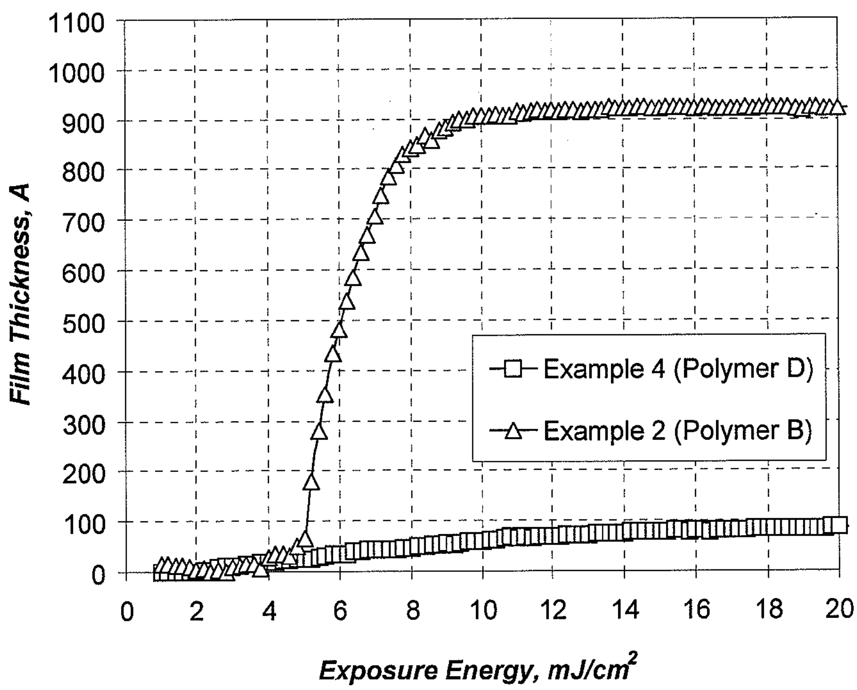
1100
1000
900
800
700
600
500
400
300
200
100
0
Film Thickness, A
0 2 4 6 8 10 12 14 16 18 20
Exposure Energy, mJ/cm2
Example 4 (Polymer D)
Example 2 (Polymer B)

FIG. 4

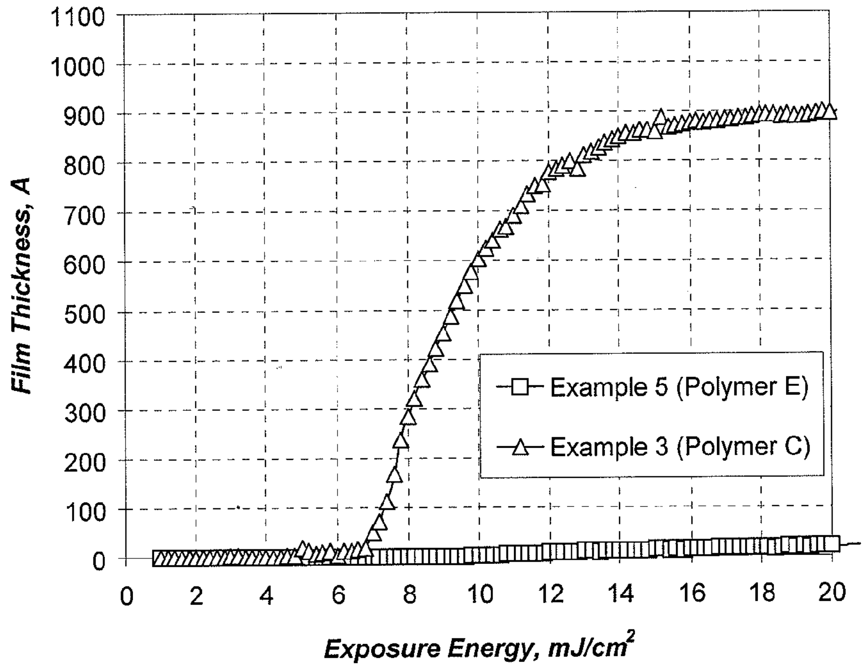

1100
1000
900
800
700
600
500
400
300
200
100
0
Film Thickness, A
0
2
4
6
8
10
12
14
16
18
20
Exposure Energy, mJ/cm2
Example 5 (Polymer E)
Example 3 (Polymer C)


FIG. 5

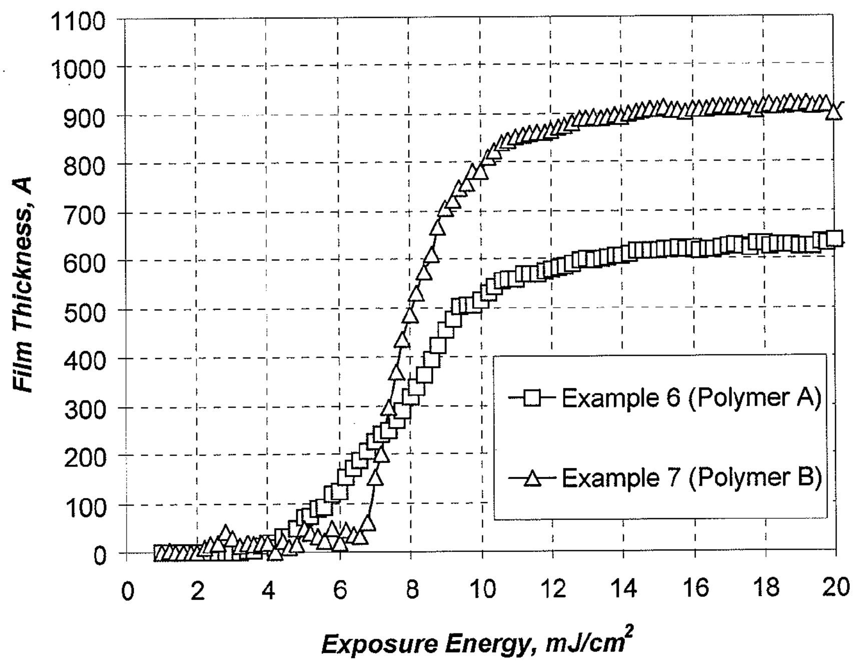

1100
1000
900
800
700
600
500
400
300
200
100
0
Film Thickness, A
0
2
4
6
8
10
12
14
16
18
20
Exposure Energy, mJ/cm2
Example 6 (Polymer A)
Example 7 (Polymer B)

FIG. 6

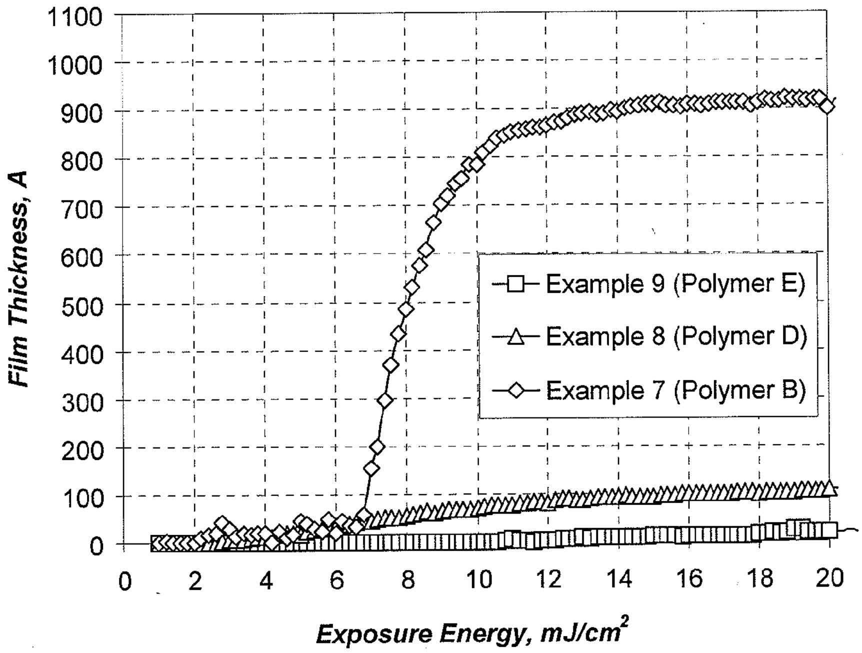


CD = N/A

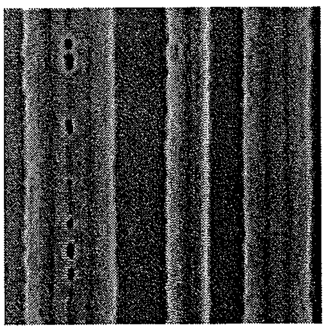

FIG. 7A

CD = 55.5nm

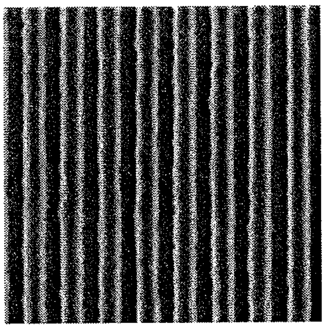

FIG. 7B

CD=48.0nm

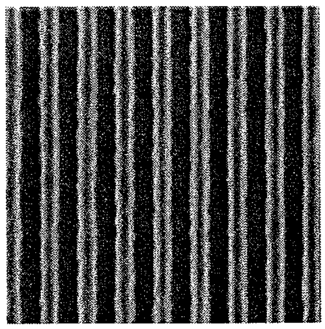

FIG. 7C

Europäisches Patentamt
European Patent Office
Office européen des brevets

# EUROPEAN SEARCH REPORT

Application Number
EP 11 18 0515

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KR 2006 0066932 A (HYNIX SEMICONDUCTOR INC [KR]) 19 June 2006 (2006-06-19)<br>* claims 1,2,6-8,11 *<br>* page 5 - page 6; examples 1-4 * | 1-7,9 | INV.<br>G03F7/039<br>G03F7/20<br>G03F7/32 |
| X | JP 9 050126 A (FUJITSU LTD)<br>18 February 1997 (1997-02-18)<br>* abstract; examples 26-29 *<br>* claims 1,2,4,5,7,8,9,13 * | 1-6,9 | |
| X,P | WO 2011/105626 A1 (FUJIFILM CORP [JP]; IWATO KAORU [JP]; KATAOKA SHOHEI [JP]; TARUTANI SH) 1 September 2011 (2011-09-01)<br>* page 218; example 20; tables 3-1 *<br>* page 31, line 13 - page 36 *<br>* page 85; compounds A-20 *<br>* claims 1-3,12 *<br>* page 16, line 4 - line 12 * | 1-10 | |
| A | HAVARD J M ET AL: "PHOTORESISTS WITH REDUCED ENVIRONMENTAL IMPACT: WATER-SOLUBLE RESISTS BASED ON PHOTO-CROSS-LINKING OF A SUGAR-CONTAINING POLYMETHACRYLATE",<br>MACROMOLECULES, AMERICAN CHEMICAL SOCIETY, WASHINGTON, DC; US,<br>vol. 32, no. 1,<br>12 January 1999 (1999-01-12), pages 86-94, XP000790843,<br>ISSN: 0024-9297, DOI: 10.1021/MA981372J<br>* Resist A;<br>page 88; table 3 *<br>* page 91, column 2, line 8 - line 17 * | 1-10 | TECHNICAL FIELDS SEARCHED (IPC)<br>G03F |
| A | US 2009/176177 A1 (HAN SEOK [KR] ET AL)<br>9 July 2009 (2009-07-09)<br>* the whole document *<br>-/-- | 1-10 | |

The present search report has been drawn up for all claims

| Place of search | Date of completion of the search | Examiner |
|---|---|---|
| Munich | 19 December 2011 | Beckert, Audrey |

3

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches Patentamt
European Patent Office
Office européen des brevets

# EUROPEAN SEARCH REPORT

Application Number
EP 11 18 0515

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2003/224285 A1 (NAKAO HAJIME [JP] ET AL) 4 December 2003 (2003-12-04)<br>* paragraph [0290] *<br>----- | 1-10 | |

TECHNICAL FIELDS SEARCHED (IPC)

The present search report has been drawn up for all claims

3

| Place of search | Date of completion of the search | Examiner |
|---|---|---|
| Munich | 19 December 2011 | Beckert, Audrey |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
..................................................................
& : member of the same patent family, corresponding document

EPO FORM 1503 03.82 (P04C01)

## ANNEX TO THE EUROPEAN SEARCH REPORT ON EUROPEAN PATENT APPLICATION NO. EP 11 18 0515

This annex lists the patent family members relating to the patent documents cited in the above-mentioned European search report.
The members are as contained in the European Patent Office EDP file on
The European Patent Office is in no way liable for these particulars which are merely given for the purpose of information.

19-12-2011

| Patent document cited in search report | Publication date | Patent family member(s) | Publication date |
|---|---|---|---|
| KR 20060066932 A | 19-06-2006 | NONE | |
| JP 9050126 A | 18-02-1997 | NONE | |
| WO 2011105626 A1 | 01-09-2011 | NONE | |
| US 2009176177 A1 | 09-07-2009 | KR 20090059650 A<br>US 2009176177 A1 | 11-06-2009<br>09-07-2009 |
| US 2003224285 A1 | 04-12-2003 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 6790579 B, Goodall


### Non-patent literature cited in the description


- **TSIBOUKLIS ; NEVELL.** *Advanced Materials,* 2003, vol. 15, 647-650